# EUROPEAN PATENT APPLICATION

(11) **EP 1 826 230 A1**
(43) Date of publication of application: **29.08.2007**
(21) Application number: 05816861.8
(22) Date of filing: 15.12.2005
(51) Int. Cl.: C08G 73/12, C08F 290/14, G03F 7/038

(54) **UNSATURATED GROUP-CONTAINING POLYIMIDE RESIN, PHOTOSENSITIVE RESIN COMPOSITION CONTAINING SAME, AND CURED PRODUCT THEREOF**

(30) Priority: 16.12.2004 JP 2004363858
(71) Applicant: NIPPON KAYAKU KABUSHIKI KAISHA, Tokyo 102-8172 (JP)
(72) Inventor: UEHARA, Ryuji NIPPON KAYAKU KABUSHIKI KAISHA, Kita-ku, Tokyo 115-8588 (JP); TANAKA, Ryutaro NIPPON KAYAKU KABUSHIKI KAISHA, Kita-ku, Tokyo 115-8588 (JP)
(74) Representative: Gille Hrabal Struck Neidlein Prop Roos
(86) International application number: PCT/JP2005/023027
(87) International publication number: WO 2006/064867

(57) **Abstract**

The present invention provides a photosensitive resin which is rich in heat resistance and flexibility. The present invention relates to the unsaturated group-containing polyimide resin obtained through a reaction between a polyimide resin, which is obtained by polyimidization of a polyamide acid obtained through a reaction between a diamino-6-hydroxypyrimidine (diamine component (A)) and an aromatic tetrabasic acid dianhydride (C), and an unsaturated group-containing compound, preferably a compound having a reactive group such as an acid anhydride group or isocyanate group and an unsaturated group; relates to a photosensitive resin composition containing such resin, a crosslinking agent and photopolymerization initiator; and relates to a cured product of such a resin composition. The photosensitive resin composition containing such an unsaturated group-containing polyimide resin has good development characteristic and photosensitivity, and enables to form the polyimide resin cured film without requiring a heat treatment step. The cured film has flexibility and is excellent in solvent resistance as well.

## Description

### Technical Field

The present invention relates to a novel unsaturated group-containing polyimide resin, and a photosensitive resin composition containing the resin, a cross-linking agent and a photo-polymerization initiator, and a cured product thereof.

### Background Art

Recently, with requirement of higher precision and higher densification to a printed wiring board aiming at downsizing and weight saving or improvement of communication speed of mobile devices, request to a solder mask has also become increasingly higher, and it is required to have excellent performances in solder heat resistance, electroless gold plating resistance, adhesion to a substrate, chemical resistance and the like, while maintaining more flexibility, as compared with conventional request; and several proposals have been provided thereto.
To respond to these requirements, many proposals have been provided on the photosensitive resin composition mainly composed of a polyimide resin.

For example, Patent Literature 1 or Patent Literature 2 has proposed a resin composition mainly composed of a polyimide precursor having photosensitivity, however, it has a problem of making elaborate pattern-formation difficult, caused by thermal deformation of a pattern to be formed in imidization, because an imidization step by heating is needed. In addition, Patent Literature 3 has proposed a resin composition mainly composed of a soluble polyimide resin having photosensitivity, however, it still had a problem that good sensitivity and good development characteristic could not be compatible.
As described above, in a solder mask composition having a resin composition mainly composed of a polyimide resin, a sufficiently satisfactory product in view of sensitivity, development characteristic, flexibility and the like, which are recent strong improvement requirements, has not been created.
Patent Literature 1: JP 5-5995 A
Patent Literature 2: JP 5-19475 A
Patent Literature 3: JP 11-52572 A

### Disclosure of Invention

### Problem to be Solved by the Invention

It is an object of the present invention to develop a polyimide resin having sufficiently satisfactory performance in view of sensitivity, development characteristic, flexibility and the like, in a solder mask composition having a resin composition mainly composed of a polyimide resin.

### Means for solving the problem

The present inventors have intensively studied a way to solve the above-described problems, and found that a novel unsaturated group-containing polyimide resin having a specified structure can solve the above problems, and have thus completed the present invention.

Namely, the present invention relates to:
(1) An unsaturated group-containing polyimide resin obtained by subjecting a polyimide resin, which is obtained by polyimidization of a polyamide acid obtained by a reaction of a diamine component (A) represented by the following formula (1) 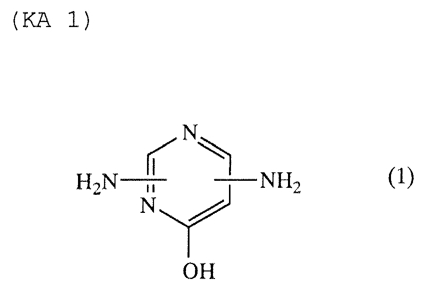 and an aromatic tetrabasic acid dianhydride (C), to a reaction with an unsaturated group-containing compound.
(2) An unsaturated group-containing polyimide resin obtained by subjecting a polyimide resin, which is obtained by polyimidization of a polyamide acid obtained by a reaction of the diamine component (A) represented by the formula (1) according to the above (1), a diamine component (B) other than the diamine component (A), and the aromatic tetrabasic acid dianhydride C, to the reaction with the unsaturated group-containing compound.
(3) The unsaturated group-containing polyimide resin according to the above (1) or the above (2), wherein the aromatic tetrabasic acid dianhydride (C) is a compound represented by the following formula (2): 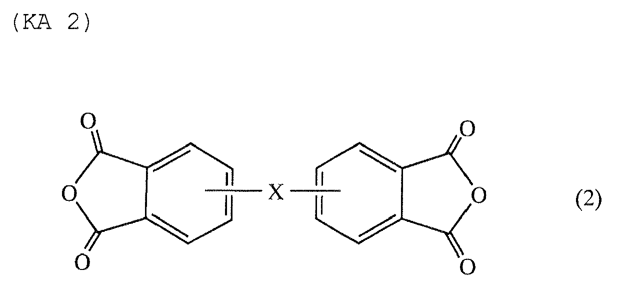 wherein X represents a direct bond, -O-, -CO- or SO₂- in the formula (2), or a compound represented by the following formula (3): 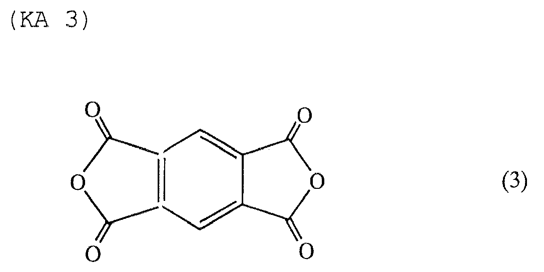
(4) The unsaturated group-containing polyimide resin according to the above (2) or the above (3), wherein the diamine component (B) is at least one or more aromatic diamines selected from 4,4'-diaminodiphenyl ether, 3,4'-diaminodiphenyl ether, 1,3-bis(3-aminophenoxy)benzene and 3,5-diaminobenzoic acid.
(5) The unsaturated group-containing polyimide resin according to any one of the above (1) to (4), wherein the unsaturated group-containing compound is one kind or 2 or more kinds selected from the group consisting of 2-methacryloyloxyethyl isocyanate, 2-acryloyloxyethyl isocyanate and maleic anhydride.
(6) A photosensitive resin composition characterized by having the unsaturated group-containing polyimide resin according to any one of the above (1) to (5), a cross-linking agent and a photo-polymerization initiator.
(7) A cured product obtained by curing the photosensitive resin composition according to the above (6).
(8) The cured product according to the above (7), which is a flexible cured film.
(9) A polyimide resin solution containing a polyimide resin, which is obtainable by polyimidization of a polyamide acid obtained by a reaction of diamino-6-hydroxypyrimidine and an aromatic tetrabasic acid dianhydride, and a solvent.
(10) The polyimide resin solution according to the above (9), wherein the polyamide acid has a viscosity at 25°C of 90 to 250 mPa·s, in the polyamide acid varnish with a solid content of 20%.

### Advantages of the Invention

The photosensitive resin composition using the unsaturated group-containing polyimide resin of the present invention is one having balanced performance between development characteristic and photosensitivity, in particular good photosensitivity, and is capable of forming a polyimide cured product, in particular a cured film, without requiring a heat treatment step. In addition, the resultant cured film from the photosensitive resin composition has flexibility and is also excellent in solvent resistance.

### Best Mode for Carrying out the Invention

The present invention will be explained in detail.

The unsaturated group-containing polyimide resin of the present invention can be obtained by subjecting the polyimide resin, which is obtained by imidization of the polyamide acid obtained by a reaction of a diamine component (A) represented by the above formula (1) and an aromatic tetrabasic acid dianhydride (C), to a reaction with an unsaturated group-containing compound.

In this case, a diamine component (B) other than the diamine component (A) represented by the formula (1) may also be used in combination.

As a specific example of the diamine component (A) (diamino-6-6-hydroxypyrimidine) represented by the formula (1), 2,4-diamino-6-hydroxypyrimidine, 2,5-diamino-6-hydroxypyrimidine, and 4,5-diamino-6-hydroxypyrimidine are included; and 2,4-diamino-6-hydroxypyrimidine is preferable.

The diamine component (B), other than diamine component (A) represented by the formula (1), includes aromatic diamines comprising diaminodiphenylpropanes such as 4,4'-diaminodiphenylpropane and 3,4'-diaminodiphenylpropane; bisanilines such as 4,4'-[1,3-phenylenebis(1-methylidene)]bisaniline, 4,4'-[1,4-phenylenebis(1-methylidene)]bisaniline and p-phenylenediamine; phenylenediamines such as m-phenylenediamine and chloro-p-phenylenediamine; diaminodiphenyl ethers such as 4,4'-diaminodiphenyl ether (described as 4,4'-oxydianiline in Examples), 2,4'-diaminodiphenyl ether and 3,4'-diaminodiphenyl ether; 1,3-bis(3-aminophenoxy)benzene; 1,4-bis(4-aminophenoxy)benzene; diaminodiphenylmethanes such as 4,4'-diaminodiphenylmethane, 3,4'-diaminodiphenylmethane and 2,4'-diaminodiphenylmethane; diaminodiphenyl sulfides such as 4,4'-diaminodiphenyl sulfide and 3,4'-diaminodiphenyl sulfide; diaminodiphenyl sulfones such as 4,4'-diaminodiphenyl sulfone and 3,4'-diaminodiphenyl sulfone; diaminonaphthalenes such as 1,5-diaminonaphthalene; benzidines such as 3,3'-dimethylbenzidine, 3,3',5,5'-tetramethylbenzidine, 3,3'-dichlorobenzidine, 2,2'-dichlorobenzidine, and 3,3',5,5'-tetrachlorobenzidine; aromatic diamines such as 2,4-bis(β-amino-t-butyl)toluene, bis(p-β-amino-t-butylphenyl) ether, 3,5-diaminobenzoic acid, and 3,5-bis(4-aminophenoxy)benzoic acid; and the like. Preferable one is at least one or more aromatic diamines selected from the group consisting of diaminodiphenyl ethers, in particular, 4,4'-diaminodiphenyl ether, 2,4'-diaminodiphenyl ether, 3,4'-diaminodiphenyl ether and the like, and 1,3-bis(3-aminophenoxy)benzene and 3,5-diaminobenzoic acid.

Ratio of a diamine component (B) relative to the diamine component (A), in the case where the diamine component (A) and the diamine component (B) other than the diamine component (A) are used in combination, is 0.1 to 100, preferably 0.1 to 2 of the diamine component (B), providing the diamine component (A) as a molar ratio of 1.

Any aromatic tetrabasic acid dianhydride (C) can be used without being especially limited, as long as it is a dianhydride compound having a structure where 4 carboxyl groups are bonded to an aromatic ring, and a specific example of the aromatic tetrabasic acid dianhydride (C), which can be used, includes pyromellitic acid dianhydride; biphenyltetracarboxylic acid dianhydride such as 3,3',4,4'-biphenyltetracarboxylic acid dianhydride, and 2,2',3,3'-biphenyltetracarboxylic acid dianhydride; 2,3,4,5-thiophene tetracarboxylic acid dianhydride, 2,2-bis(3,4-dicarboxyphenyl)propanoic acid dianhydride, bis(3,4-dicarboxyphenyl)sulfonic acid dianhydride, 3,4,9,10-perylenetetracarboxylic acid dianhydride, benzophenone tetracarboxylic acid dianhydride, oxydiphthalic acid dianhydride and the like. Among these, the aromatic tetrabasic acid dianhydride represented by the above-described formula (2) or (3) is preferable, in the formula (2), such one is more preferable that X is a direct bond, O or SO₂, and one is most preferable where X is a direct bond.
As an example of the aromatic tetrabasic acid dianhydride represented by the above-described formula (2) or (3), biphenyltetracarboxylic acid dianhydride, benzophenonetetracarboxylic acid dianhydride, pyromellitic acid dianhydride or the like is included. A preferable example of the aromatic tetrabasic acid dianhydride represented by the above formula (2) includes biphenyltetracarboxylic acid dianhydride, oxydiphthalic acid dianhydride or bis(dicarboxyphenyl)sulfonic acid dianhydride, more preferably bis(3,4-dicarboxyphenyl)sulfonic acid dianhydride, and a preferable example of the aromatic tetrabasic acid dianhydride represented by the above formula (3) includes pyromellitic acid dianhydride. Among these, pyromellitic acid dianhydride and 3,3',4,4'-biphenyltetracarboxylic acid dianhydride are particularly preferable.

These aromatic tetrabasic acid dianhydrides (C) may be used alone, or two or more kinds in combination.

In the present invention, use ratio of the above aromatic tetrabasic acid dianhydride (C) and the diamine component (the diamine component (A) and the diamine component (B) used in combination, if necessary) is usually about 0.5 to 4 moles, preferably about 0.5 to 3 moles of the latter (total of the diamine component (A) and the diamine component (B)), relative to 1 mol of the former, depending on a kind of the diamine component, the latter is used in a ratio of 0.5 to 1.5 mol, preferably 0.7 to 1.3 mol. Depending on the cases, use of 1 mol or more, preferably about 1 to 3 moles of the latter relative to 1 mol of the former is preferable, and use of excess amount of the latter is preferable, because the polyamide acid having a terminal amino group is obtained.

The polyamide acid can be obtained by dissolving the above aromatic tetrabasic acid dianhydride (C), the diamine component (A) and the diamine component (B), which is used in combination, if necessary, into an organic solvent in predetermined ratio, and by subjecting the solution to a reaction. The organic solvent, which can be used here, is not especially limited as long as being a good solvent of the resultant polyamide acid. A specific example of the organic solvent to be used includes N,N-dimethylformamide (hereinafter DMF), N,N-dimethylacetamide (hereinafter DMAC), N,N-dimethylmethoxyacetamide, N-methyl-2-pyrrolidone (hereinafter NMP), 1,3-dimethyl-2-imidazolidinone, caprolactam, N-methylcaprolactam, dimethylsulfoxide, dimethylsulfone, sulfolane, tetramethylurea, hexamethylphosphoramide, phenol, cresol, xylenol, chlorophenol, ethylene glycol, diethylene glycol, triethylene glycol, glyme, diglyme, triglymeand the like. These solvents preferably dissolve the polyamide acid at room temperature, in a concentration of at least about 20% (weight) (hereinafter the same unless otherwise specified), preferably equal to or higher than 30%, relative to total amount. These solvents may be used alone, or by mixing two or more kinds.

Use amount of a solvent is not especially limited as long as being a level sufficient to advance a reaction, however, usually use of about an amount of not exceeding 30% by weight, as solid content concentration, is preferable. The use amount over 30% by weight increases viscosity too high and may sometimes cause handling difficulty. The reaction is carried out usually at 45 to 100°C for 1 to 20 hours, preferably 5 to 10 hours. A reaction progress can be known by observation of increase in viscosity of a reaction solution associated with progress of a reaction.

In the present invention, the polyamide acid obtained as above may be separated as an objective substance, however, it is favorable to supply the above reaction solution containing the polyamide acid as it is, without separation of the polyamide acid, to a subsequent imidization reaction. It should be noted that, in the case where separation of the polyamide acid is desired, for example, the following processing may be considered. By pouring a reaction solution into a poor solvent such as water, methanol or the like, or by pouring a poor solvent such as water, methanol or the like into a reaction solution, the polyamide acid can be precipitated. By filtering this precipitated substance and washing, desired polyamide acid can be isolated.

The polyamide acid solution containing the polyamide acid and an organic solvent can also be used as the polyamide acid varnish. As an organic solvent in that case, the above-described good solvent for the polyamide acid may be used. Concentration of the polyamide acid in the polyamide acid varnish is equal to or higher than 10%, preferably equal to or higher than 15%; and equal to or lower than about 30%, preferably equal to or lower than about 27% and more preferably about 25%, relative to total amount. In addition, the polyamide acid used in the polyamide acid solution does not especially affect as long as one obtained as above, however, it is preferable to be a solution having a concentration of the polyamide acid of about 20%, and having a viscosity of the solution at 25°C of about 90 to 250 mPa·s, preferably about 100 to 230 mPa·s, and more preferably about 110 to 200 mPa·s.

By imidization of the polyamide acid obtained as above, the polyimide resin can be obtained. As an imidization method, for example, the following imidization method is included; into the above reaction solution containing the polyamide acid, or into a solution dissolved the polyamide acid in the above organic solvent in the case where the polyamide acid is isolated, a solvent which is capable of forming an azeotrope with water (hereinafter may be referred to as an azeotrope solvent) such as toluene or the like is added, if necessary, and then a catalyst is added, if necessary, followed by heating and removing water, which generates by an imidization reaction, by azeotropic dehydration in the case where the azeotrope solvent is added. Usually, a method for imidization while removing water, which generates by an imidization reaction, by azeotropic dehydration is preferable. As the azeotrope solvent, an aromatic hydrocarbon such as toluene, xylene or the like is included. The addition amount of the solvent is preferably 10 to 30% by weight of total amount of a reaction solution. As a catalyst, acetic anhydride, β-picoline, pyridine, hydroxypyridine, γ-butyrolactone or the like is included, and it is preferably to add, if necessary, so as to be 1 to 10% by weight relative to total amount of the reaction solution. Temperature of an imidization reaction is usually equal to or higher than 150°C, preferably equal to or higher than 190°C, and more preferably equal to or higher than 200°C, and usually equal to or lower than 400°C, and preferably equal to or lower than about 300°C. Imidization may be carried out continuously while removing a solvent.

A polyimide resin solution containing the resultant polyimide resin and an organic solvent can also be used as a polyimide resin varnish. As an organic solvent in that case, usually the above-described good solvent for the polyamide resin may be used. Concentration of the polyimide resin in the polyimide resin varnish is equal to or higher than 10%, preferably equal to or higher than 15%; and equal to or lower than about 30%, preferably equal to or lower than about 27% and more preferably about 25%, relative to total amount. In addition, the polyimide resin used in the polyimide resin solution is preferably in a form of a solution with a concentration of the polyimide resin of about 20%, and the solution has a viscosity at 25°C of about 90 to 230 mPa·s, preferably about 100 to 200 mPa·s, and more preferably about 110 to 190 mPa·s.

In the case where the aromatic tetrabasic acid dianhydride of the formula (2) is used as the tetrabasic acid dianhydride, the polyimide resin obtained as above is considered to have, for example, a structure as described below. The formula (4) shows an example of the polyimide resin, where 2 kinds of diamine components are used in combination, and the formula (5) shows an example of the polyimide resin, where 1 kind of diamine component is used, respectively. In addition, in the formula (4), R represents a residual group of a diamine component (B) other than a diamine component (A) ; and in the formulae (4) and (5), X has the same meaning as in the formula (2), and a, b and n represent an integer, respectively.

Values of a and b vary depending on ratio of diamine components to be used, and n is not especially limited, and usually 1 to 100, preferably 1 to 30, and further preferably about 1 to 10.

It should be noted that, in the case where pyromellitic acid represented by the formula (3) is used as the tetrabasic acid dianhydride, a moiety of a structure of a tetrabasic acid dianhydride in the following formula may be replaced by a structure of the formula (3) instead of the formula (2).

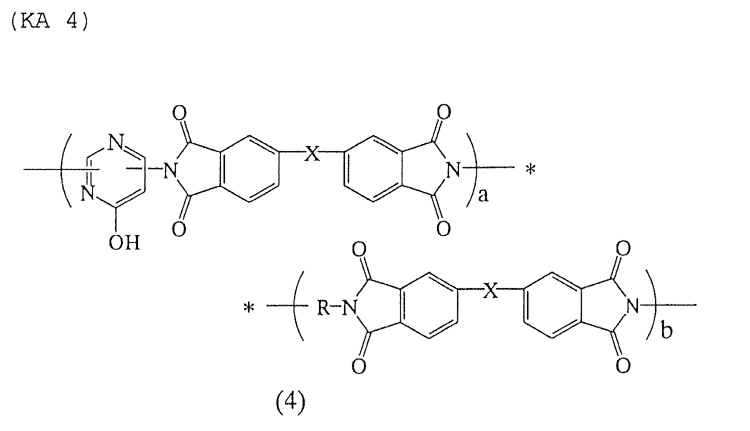

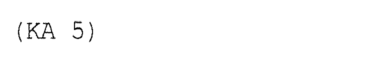

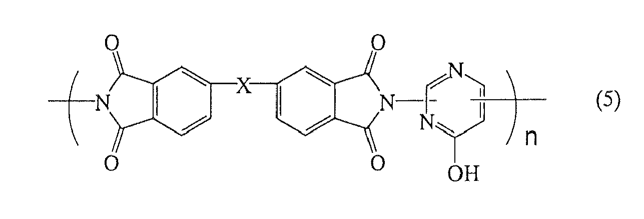

Then, explanation will be given on a method for subjecting the polyimide resin obtained as above and an unsaturated group-containing compound to a reaction.

The resultant polyimide resin has hydroxyl groups in the main chain, and in addition, in the case where a diamine component is used in excess relative to an acid anhydride, an amino group is present at the molecular terminal. By subjecting the unsaturated group-containing compound to a reaction with these functional groups, an unsaturated group can be introduced.

As the unsaturated group-containing compound, which can be used here, any compound may be used as long as having a functional group which have reactivity with an hydroxyl group, or both an hydroxyl group and an amino group, and an unsaturated group, in the molecule; for example, a compound having an acid anhydride group and an unsaturated group, a compound having an isocyanate group and an unsaturated group (preferably an ethylenic unsaturated group) or the like is included as a preferable example. As an unsaturated group, usually a group having an ethylenic double bond is included; for example, a (meth)acryloyl group (an acryloyl group and/or a methacryloyl group) or the like is included.

A compound having an isocyanate group and a (meth) acryloyl group is more preferable, which is generally well-known by those skilled in the art. Most generally, a (meth) acrylate compound having an isocyanate group may be included. As a group having an isocyanate group in the compound, a C2 to C15, preferably C2 to C12 organic group may be included. The organic group may contain a phenyl group, an oxygen atom, a nitrogen atom or the like, and in the case where a phenyl group is contained, a compound having an isocyanate group at the phenyl group is preferable. One of a preferable compound is an isocyanate C2 to C6 alkyl (meth)acrylate.

It should be noted that, in the present invention, it is preferable to use a reaction solution containing the polyimide resin as it is, without removing a solvent used in producing the polyimide resin, to the present reaction to introduce an unsaturated group. A solvent may be added, if necessary, to adjust concentration of a reaction substrate. As a specific example of a solvent, which may be used as an additional solvent, includes DMF, DMAC, N,N-dimethylmethoxyacetamide, NMP, 1,3-dimethyl-2-imidazolidinone, caprolactam, N-methylcaprolactam, dimethylsulfoxide, dimethylsulfone, sulfolane, tetramethylurea, hexamethylphosphoramide, glyme, diglyme, triglyme or the like; and preferable one is DMF, DMAC and NMP.

First of all, explanation will be given on a method for introducing an unsaturated group by subj ecting a compound having an acid anhydride group and an unsaturated group to a reaction with the polyimide resin.

A specific example of the compound having an acid anhydride group and an unsaturated group, which can be used here, includes maleic anhydride or the like. In a reaction between the compound having an acid anhydride group and an unsaturated group, and the polyimide resin, reaction condition commonly known per se, which is adopted in a reaction between an acid anhydride and a compound having a hydroxyl group or an amino group, can be applied. Namely, the polyimide resin may be reacted with the compound having an acid anhydride group and an unsaturated group in a solvent, by the addition of a catalyst, if necessary. Concentration in a reaction is not especially limited, as long as being such concentration that the polyimide resin, the compound having an acid anhydride group and an unsaturated group, and the resultant unsaturated group-containing polyimide resin are dissolved, however, the concentration of total amount of raw material components and reaction products is 5 to 50% by weight, preferably 10 to 30% by weight. Concentration in a reaction can be adjusted by using the above-described solvent. Reaction temperature is 5 to 50°C, and preferably 10 to 40°C. Reaction time is 1 to 50 hours, and preferably 4 to 20 hours. Molar ratio of the polyimide resin and the compound having an acid anhydride group and an unsaturated group is 0.1 to 1. 5 molar equivalent relative to total amount (molar ratio) of a hydroxyl group and an amino group of the polyimide resin, as standard (1 molar equivalent).

In the reaction, a catalyst may be added, if necessary. A catalyst, which may be used, is a compound having a tertiary amino group, and specifically includes triethylamine, pyridine or the like. A reaction progress can be known by measurement of acid value of a resin in a reaction solution.

Then, explanation will be given on a method for introducing an unsaturated group by subjecting a compound having an isocyanate group and an unsaturated group to a reaction with the polyimide resin.

A specific example of the compound having an isocyanate group and an unsaturated group, which can be used, includes 2-methacryloyloxyethyl isocyanate, 2-acryloyloxyethyl isocyanate or the like is included. These can be available on the market, for example, as Karenz^{™} MOI and Karenz^{™} AOI (both are trade marks of products, produced by Showa Denko K.K.) or the like.

In a reaction between the polyimide resin and the compound having an isocyanate group and an unsaturated group, reaction condition commonly known per se, which is applied to an isocyanate group and a compound having a hydroxyl group or an amino group, can be applied. Namely, the polyimide resin may be reacted with the compound having an isocyanate group and an unsaturated group, in a solvent, by the addition of a catalyst, if necessary. Concentration in a reaction is not especially limited, as long as being such concentration that the polyimide resin, the compound having an isocyanate group and an unsaturated group, and the resultant unsaturated group-containing polyimide resin are dissolved, however, the concentration of total amount of raw material components and reaction products is 5 to 50% by weight, preferably 10 to 30% by weight. Concentration in a reaction can be adjusted by using the above-described solvent. Reaction temperature is 5 to 50°C, and preferably 10 to 40°C. Reaction time is 1 to 50 hours, and preferably 4 to 20 hours. Amount ratio (molar ratio) of the polyimide resin and the compound having an isocyanate group and an unsaturated group is 0.1 to 1.5 molar equivalent, relative to total amount (molar ratio) of a hydroxyl group and an amino group of the polyimide resin, as standard (1 molar equivalent). A reaction progress can be known by observation of a generation state of carbon dioxide, and an increase state of viscosity (thickening behavior).

The unsaturated group-containing polyimide resin obtained as above may be obtained as a objective substance by removing a solvent, if desired, however, in the present invention, it is favorable to use the reaction solution as it is, without removing a solvent, to prepare a resin composition of the present invention. By-products, unreacted substances and the like present in the reaction solution do not raise any particular problems. In the reaction solution after completion of a reaction between the polyimide resin obtained as above and the compound having an unsaturated group, usually 5 to 50% by weight of the unsaturated group-containing polyimide resin of the present invention is contained. In addition, the content and purity thereof can be determined by sampling a suitable amount of the reaction solution and evaporating a solvent in an oven or the like, to measure the resultant resin content.

Thus obtained unsaturated group-containing polyimide resin solution containing the unsaturated group-containing polyimide resin and the organic solvent, or an unsaturated group-containing polyimide resin solution prepared by dissolving the unsaturated group-containing polyimide resin after removing the reaction solvent, into an organic solvent again, may also be used as the unsaturated group-containing polyimide resin varnish. As the organic solvent in this case, the good solvent of the above-described polyamide resin, or one described as the additional solvent used in introducing an unsaturated group may usually be used. Concentration of the resin in the unsaturated group-containing polyimide resin varnish is equal to or higher than 10%, preferably equal to or higher than 15%, and equal to or lower than about 35%, preferably equal to or lower than about 30% and more preferably equal to or lower than about 27%, relative to total amount.

It should be noted that a method for desirably obtaining the unsaturated group-containing polyimide resin of the present invention as a solid is as follows. For example, by pouring the reaction solution into a poor solvent such as water, methanol or the like, or by pouring a poor solvent such as water, methanol or the like into the reaction solution, the unsaturated group-containing polyimide resin can be precipitated. By filtering this precipitated substance and washing, the unsaturated group-containing polyimide resin can be isolated.

Then, explanation will be given on the photosensitive resin composition of the present invention.

The photosensitive resin composition of the present invention contains the unsaturated group-containing polyimide resin of the present invention, a cross-linking agent and a photo-polymerization initiator, and an organic solvent, if necessary. In the photosensitive resin composition of the present invention, the additives such as inorganic fillers, pigments and the like, as arbitrary components, may be contained, in addition to the above essential components.

The photosensitive resin composition preferably contains an organic solvent so as to be able to form a coated film or the like. In the case where the organic solvent is contained, content thereof is equal to or higher than 30%, preferably equal to or higher than 40%, and more preferably equal to or higher than 50%, or depending on the case, equal to or higher than 60% or equal to or higher than 70% is preferable, relative to total amount of the composition, and the upper limit is usually equal to or lower than 95%, preferably equal to or lower than 90%, more preferably equal to or lower than 85%, and depending on the case, equal to or lower than 80%. Usually the solvent is used in an amount of about 60% to 85%. The remainder is the unsaturated group-containing polyimide resin, a cross-linking agent and a photo-polymerization initiator, and the additives as arbitrary components.

A solvent used includes a solvent described in the item of the polyamide resin or the polyimide resin.

As the unsaturated group-containing polyimide resin, it is favorable to use one obtained as above, namely the reaction solution as it is, without removing a solvent.

As a cross-linking agent, in the present invention, a (meth)acrylic acid derivative is preferably used. A specific example of a (meth)acrylic acid derivative, which may be used, includes 2-hydroxyethyl (meth)acrylate, 2-hydroxypropyl (meth)acrylate, 1,4-butanediol mono(meth)acrylate, carbitol (meth) acrylate, acryloyl morpholine, a half ester as a reaction product between hydroxyl group containing-(meth)acrylate and polycarboxylic acid anhydride, polyethylene glycol di(meth)acrylate, tripropylene glycol di(meth)acrylate, trimethylolpropane tri(meth)acrylate, trimethylolpropane polyethoxy tri(meth)acrylate, glycerin polypropoxy tri(meth)acrylate, di(meth)acrylate of ε-caprolactone adduct of neopentylglycol hydroxypivalate (for example, KAYARAD HX-220, HX-620 or the like, produced by NIPPON KAYAKU KABUSHIKI KAISHA), pentaerythritol tetra(meth)acrylate, poly(meth)acrylate of a reaction product between dipentaerythritol and ε-caprolactone, dipentaerythritol poly (meth) acrylate, epoxy(meth)acrylateof a reaction product between a mono- or polyglycidylated compound and (meth) acrylic acid, or the like. These cross-linking agents may be used alone or as a mixture of 2 or more kinds.

A preferable cross-linking agent includes dipentaerythritol poly (meth) acrylate such as dipentaerythritol hexa (meth) acrylate or poly (meth) acrylate of a reaction product between dipentaerythritol and ε-caprolactone, and the like.

In the above, as a hydroxyl group-containing (meth)acrylate in a half ester as a reaction product between hydroxyl group-containing (meth)acrylate and polycarboxylic acid anhydride includes, for example, 2-hydroxyethyl (meth)acrylate, 2-hydroxypropyl (meth)acrylate, 1,4-butanediol mono(meth)acrylate or the like. In addition, polycarboxylic acid anhydride includes, for example, succinic anhydride, maleic anhydride, phthalic anhydride, tetrahydrophthalic anhydride, hexahydrophthalic anhydride or the like.

Furthermore, as a mono- or polyglycidylated compound in epoxy(meth)acrylate of a reaction product between a mono- or polyglycidylated compound and (meth) acrylic acid, for example, butyl glycidyl ether, phenyl glycidyl ether, polyethylene glycol diglycidyl ether, polypropylene glycol diglycidyl ether, 1,6-hexanediol diglycidyl ether, hexahydrophthalic acid diglycidyl ester, glycerin polyglycidyl ether, glycerin polyethoxyglycidyl ether, trimethylolpropane polyglycidyl ether, trimethylolpropane polyethoxypolyglycidyl ether or the like is included.

Then, as a photo-polymerization initiator, any compounds may be used as long as they have a capability to initiate polymerization by photo irradiation, and dissolve in a solvent. A photo-polymerization initiator is classified broadly into an intra-molecular cleavage type, a hydrogen abstraction type and other types, depending on initiation mechanism; and any types may be used. As a specific example of an intra-molecular cleavage type, benzoins such as benzoin, benzoin methyl ether, benzoin ethyl ether, benzoin propyl ether, benzoin isobutyl ether and the like; acetophenones such as acetophenone, 2,2-diethoxy-2-phenylacetophenone, 1,1-dichloroacetophenone, 2-hydroxy-2-methyl-phenylpropane-1-one, diethoxyacetophenone, 1-hydroxycyclohexyl phenyl ketone, 2-methyl-1-[4-(methylthio)phenyl]-2-morpholino-propane-1-one and the like; and ketals such as acetophenone dimethylketal and benzyl dimethyl ketal; and the like are included, and as a hydrogen abstraction type, thioxanthones such as 2,4-diethylthioxanthone, 2-isopropylthioxanthone, 2-chlorothioxanthone and the like; benzophenones such as benzophenone, 4-benzoyl-4'-methyldiphenylsulfide, and 4,4'-bismethylaminobenzophenone; and the like are included; and as the other type, phosphine oxides such as 2,4,6-trimethylbenzoyl diphenyl phosphine oxide, bis(2,4,6-trimethylbenzoyl)-phenyl phosphine oxide and the like; anthraquinones such as 2-ethylanthraquinone, 2-tert-butylanthraquinone, 2-chloroanthraquinone, and 2-amylanthraquinone; and the like are included. A photo-polymerization initiator may be used alone, however, use of 2 kinds in combination, which have different initiation mechanism, is preferable; and use of an intra-molecular cleavage type and a hydrogen abstraction type in combination is more preferable. A preferable combination of photo-polymerization initiators includes a combination of acetophenones such as 2-methyl-1-[4-(methylthio)phenyl]-2-morpholino-propane-1-one and the like, and thioxanthones such as 2, 4-diethylthioxanthone and the like.

These photo-polymerization initiators may be used alone or as a mixture of 2 or more kinds, and further they may be used in combination with an accelerator such as tertiary amine such as triethanol amine, or methyldiethanol amine; or a benzoic acid derivative such as N,N-dimethylaminobenzoic acid ethyl ester, or N,N-dimethylaminobenzoic acid isoamyl ester; or the like.

The photosensitive resin composition of the present invention can be obtained by mixing the unsaturated group-containing polyimide resin of the present invention, the cross-linking agent and the photo-polymerization initiator and, if necessary, additives such as inorganic fillers, pigments and the like. Content of the unsaturated group-containing polyimide resin, the cross-linking agent, or the photo-polymerization initiator contained in the photosensitive resin composition of the present invention is as follows, providing nonvolatile matter in the photosensitive resin composition as 100% by weight.
The unsaturated group-containing polyimide resin: usually 10 to 95%, preferably 10 to 80% by weight and more preferably 15 to 45% by weight;
the cross-linking agent: usually 2 to 60% by weight, preferably 5 to 20% by weight; and
the photo-polymerization initiator: usually 0.1 to 30% by weight, preferably 1 to 10% by weight.

In addition, providing non-volatile matter in the photosensitive resin composition as 100% by weight, a photosensitive resin composition containing 1 to 60% by weight, preferably 3 to 20% by weight of the cross-linking agent, 0.1 to 30% by weight, preferably 1 to 10% by weight of the photo-polymerization initiator, 0 to 50% by weight of additives added, if necessary, and the remainder is the unsaturated group-containing polyimide resin is also a preferable one. It should be noted that, in the photosensitive resin composition of the present invention, each of the above solvents may be contained, which were used in polyamidation, polyimidization and the introduction step of an unsaturated group to the polyimide resin.

In the case where the photosensitive resin composition of the present invention is a liquid state (including slurry or the like), solid content is about 15 to 50%, preferably about 20 to 35%, relative to total amount of the liquid composition, and one containing 10 to 30%, preferably about 20 to 28% of the unsaturated group-containing polyimide resin is preferable. The remainder is an organic solvent.

The photosensitive resin composition of the present invention can be used as a dry film type solder mask composed of a structure where the resin composition is sandwiched between a supporting film and a protecting film, and the like. The photosensitive resin composition (liquid state or film-formed) of the present invention is useful as an interlayer insulating material of electronics parts, a light guide connecting between optical parts, or resist materials such as a solder mask, a cover lay and the like for a printed circuit board, and also can be used as a color filter, a printing ink, sealants, coating materials, adhesives or the like.

A cured product of the present invention is one obtained by curing the photosensitive resin composition of the present invention by irradiation of energy rays such as ultraviolet rays and the like, and curing may be carried out by a common method by irradiation of energy rays such as ultraviolet rays and the like. For example, in the case where ultraviolet rays are irradiated, an ultraviolet ray generation apparatus such as a low-pressure mercury lamp, a high-pressure mercury lamp, an ultra-high-pressure mercury lamp, a xenon lamp, an ultraviolet ray emission laser (an excimer laser or the like) or the like may be used.

The cured product of the present invention is usually mounted on a substrate in layers, and a specific example of a substrate mounted with such cured product includes, for example, electric/electronics/optical parts such as a printed board, a photoelectron substrate or an optical substrate, wherein such cured product is used as a resist film, an interlayer insulating material for a build-up construction method or an optical guide. Products where these substrates are utilized include, for example, computers, household electric appliances, mobile devices and the like. Film thickness of such fabricated laminar cured product is usually about 0.5 to 160 µm, and about 1 to 100 µm is preferable.

In the above, a printed wiring board using the photosensitive resin composition of the present invention can be obtained, for example, as follows. Namely, in the case where a liquid photosensitive resin composition of the present invention is used, the photosensitive resin composition of the present invention is coated onto a printed wiring board in a film thickness of 5 to 160 µm, preferably 10 to 100 µm, by a method such as a screen printing method, a spraying method, a roll coating method, an electrostatic coating method, a curtain coating method, a bar coating method or the like, and then drying the coated film usually at 50 to 110°C, preferably 60 to 100°C for 10 to 90 minutes, preferably 30 to 60 minutes to form a coated film.

Subsequently, high energy rays such as ultraviolet rays and the like are directly or indirectly irradiated through a photo-mask formed with an exposure pattern of a negative film or the like, in an intensity of usually 10 to 2000 mJ/cm², preferably 300 to 1000 mJ/cm², and then an unexposed part is developed using a developing solution to be described later, for example, by spraying, oscillating immersion, brushing, scrubbing or the like. Then, by further irradiation of ultraviolet rays, if necessary, and subsequent heat treatment usually at a temperature of 100 to 400°C, preferably 140 to 300°C for 0.5 to 5 hours, preferably 0.8 to 3 hours, a printed wiring board having a permanent protective film satisfying various characteristics such as transparency, adhesiveness, pencil hardness, solvent resistance, acid resistance, heat resistance, gold plating resistance and the like, as well as excellent in flexibility, is obtained.

As aqueous alkaline solution used in the above development, an inorganic alkaline aqueous solution such as potassium hydroxide, sodium hydroxide, sodium carbonate, potassium carbonate, sodium hydrogen carbonate, potassium hydrogen carbonate, sodium phosphate, potassium phosphate or the like or an organic alkaline aqueous solution such as tetramethylammonium hydroxide, tetraethylammonium hydroxide, tetrabutylammonium hydroxide, monoethanolamine, diethanolamine, triethanolamine or the like is included.

Concentration of the aqueous alkaline solution is 0.1% by weight to 10% by weight, and preferably 1% by weight to 5% by weight. Development temperature is 10°C to 40°C, preferably 20°C to 30°C. Development time is usually 10 seconds to 120 seconds.

The film obtained as above can be suitably used as an insulating film of electric/electronics materials, specifically, an interlayer insulating film, and a protecting-modification film of silicon surface.

The present invention will be described below in more specifically by examples; however, the present invention should not be limited thereto.

### Example 1

Into a three-necked flask equipped with a dry nitrogen gas introducing tube, a condenser, a thermometer and a stirrer, 218 g of NMP and 25.23 g (0.2 mol) of 2,4-diamino-6-hydroxypyrimidine (hereinafter DAHP) were charged, and nitrogen gas was flown, and the solution was heated up to 60°C under fierce stirring. Then, 29.42 g (0.1 mol) of 3,3',4,4'-biphenyltetracarboxylic acid dianhydride (hereinafter BPDA) was added thereto, to be subjected to a reaction at 100°C for 15 hours. After cooling the solution to room temperature, under nitrogen pressurization, the solution was filtered through a PTFE (poly(tetrafluoroethylene))membrane (3 µm) to remove impurities and 273 g of the polyamide acid varnish with a solid content of 20% by weight were obtained. This varnish had a viscosity at 25°C of 180 mPa·s.
A part of the varnish was taken out to pour into methanol, followed by filtering a precipitated substance and drying in vacuum at 100°C to isolate the polyamide acid, which was confirmed to have a desired structure by NMR measurement. In addition, result of GPC measurement showed number average molecular weight to be 1100, and weight average molecular weight to be 1900.
NMR measurement was carried out in a DMSO-d6 solvent.
NMR (δ, ppm, CDCl₃): 4.6, 4.9, 6.2, 6.4, 9.6 to 9.9, 13.1 br GPC measurement was carried out under the following conditions:
Column: Shodex KD-806M × 3
Elution solution: 10 mM, dimethylformamide containing lithium bromide
Flow rate: 1.0 mL/min
Temperature: 40°C
Standard substance: Polystyrene

Into the three-necked flask, 250 g of the polyamide acid varnish obtained as above was charged, a Dean-Stark condenser was installed, 50 mL of toluene was added, the inner temperature was raised up to 200°C, and water generated with imidization was distilled off along with toluene as an azeotrope. Heating, stirring and refluxing were continued until water was no more distilled. The resultant reaction solution (the polyimide resin varnish: a solid content of 17%) had a viscosity of 165 Pa·s.

A part of this polyimide resin varnish was taken out to pour into methanol, followed by filtering a precipitated polyimide resin, washing with methanol and drying under reduced pressure at 150°C to isolate a powdered polyimide resin. Measurement of infrared spectrum of the resultant polyimide resin powder by a KBr tablet method revealed disappearance of absorption around 1700 cm⁻¹ derived from a carboxylic acid, only absorption around 1750 cm⁻¹ derived from an imide bond, and progress of substantially 100% imidization. Absorption maximum by a KBr tablet method: λmax 1751 cm⁻¹

To 50 g of the polyimide resin varnish obtained as above, 3 g (0.019 mol) of Karenz^{™} MOI (2-methacryloyloxyethyl isocyanate, produced by Showa Denko K.K.) was added, which was subjected to a reaction at 25°C for 6 hours under stirring. By termination of carbon dioxide generation, completion of the reaction between the polyimide resin and 2-methacryloyloxyethyl isocyanate was confirmed. In this reaction solution, 25% by weight of the unsaturated group-containing polyimide resin of the present invention was contained.

Absorption maximum of the unsaturated group-containing polyimide resin by a KBr tablet method: λmax 1749 cm⁻¹.

In the present example, by using 1.86 g (0. 019 mol) of maleic anhydride, instead of Karenz^{™} MOI, the corresponding unsaturated group-containing polyimide resin of the present invention can be obtained.

### Example 2

Into a three-necked flask equipped with a dry nitrogen gas introducing tube, a condenser, a thermometer and a stirrer, 188 g of NMP and 25.2 g (0.2 mol) of DAHP were charged, nitrogen gas was flown, and the solution was heated up to 45°C under fierce stirring. Then, 21.8 g (0.1 mol) of pyromellitic anhydride (hereinafter PMDA) was added thereto, and subjected to a reaction at 80 to 90°C for 10 hours to obtain the polyamide acid varnish with a solid content of 20% by weight. This varnish had a viscosity at 25°C of 154 mPa·s. The structure of the resultant polyamide acid was confirmed by an infrared spectrum. Absorption maximum by a KBr tablet method: λmax 1698 cm⁻¹

Using the reaction solution containing the resultant polyamide acid, the reaction solution containing the polyimide resin was obtained by carrying out polyimidization similarly as in Example 1. This reaction solution had a viscosity at 25°C of 140 Pa·s. In addition, progress of nearly 100% polyimidization was confirmed similarly as in Example 1. Absorption maximum by a KBr tablet method: λmax 1752 cm⁻¹

Using the reaction solution containing the resultant polyimide acid, a reaction solution containing the unsaturated group-containing polyimide resin of the present invention was obtained by subjecting the polyimide resin to a reaction with Karenz^{™} MOI similarly as in Example 1. In this reaction solution, 20% by weight of the unsaturated group-containing polyimide resin of the present invention was contained.
Absorption maximum of the unsaturated group-containing polyimide resin by a KBr tablet method: λmax 1751 cm⁻¹.

### Example 3

Into a three-necked flask equipped with a dry nitrogen gas introducing tube, a condenser, a thermometer and a stirrer, 614 g of NMP, 25,2g of DAHP (0.2 mol) and 40.1 g (0.2 mol) of 4,4'-oxydianiline (hereinafter 4,4'-ODA) were charged, nitrogen gas was flown, and the solution was heated up to 45°C under fierce stirring. Then, 88.3 g (0.3 mol) of BPDA was added thereto, and subjected to a reaction at 80 to 90°C for 10 hours to obtain the polyamide acid varnish with a solid content of 20% by weight. This varnish had a viscosity at 25°C of 165 mPa·s. The structure of the resultant polyamide acid was confirmed by an infrared spectrum.
Absorption maximum by a KBr tablet method: λmax 1701 cm⁻¹
This polyamide acid varnish had a viscosity at 25°C of 110 mPa·s.

Using the reaction solution containing the resultant polyimide acid, a reaction solution containing the polyimide resin was obtained by carrying out polyimidization similarly as in Example 1. This reaction solution had a viscosity at 25°C of 140 mPa·s. In addition, progress of nearly 100% polyimidization was confirmed similarly as in Example 1. Absorption maximum by a KBr tablet method: λmax 1750 cm⁻¹

Using the reaction solution containing the resultant polyimide acid, a reaction solution containing the unsaturated group-containing polyimide resin of the present invention was obtained by subjecting the polyimide resin to a reaction with Karenz^{™} MOI similarly as in Example 1. In this reaction solution, 24% by weight of the unsaturated group-containing polyimide resin of the present invention was contained.
Absorption maximum of the unsaturated group-containing polyimide resin by a KBr tablet method: λmax 1.749 cm⁻¹.

### Example 4

Into a three-necked flask equipped with a dry nitrogen gas introducing tube, a condenser, a thermometer and a stirrer, 522 g of NMP, 25.2 g (0.2 mol) of DAHP and 40.1 g (0.2 mol) of 4,4'-ODA were charged, nitrogen gas was flown, and the solution was heated up to 45°C under fierce stirring. Then, 65.4 g (0.3 mol) of PMDA was added thereto, and subjected to a reaction at 80 to 90°C for 10 hours to obtain the polyamide acid varnish with a solid content of 20% by weight. The structure of the resultant polyamide acid was confirmed by an infrared spectrum. Absorption maximum by a KBr tablet method: λmax 1702 cm⁻¹ This varnish had a viscosity at 25°C of 174 mPa·s.

Using the reaction solution containing the resultant polyamide acid, a reaction solution containing the polyimide resin was obtained by carrying out polyimidization similarly as in Example 1. This reaction solution had a viscosity at 25°C of 140 mPa·s. In addition, progress of nearly 100% polyimidization was confirmed similarly as in Example 1.

Using the reaction solution containing the resultant polyimide acid, a reaction solution containing the unsaturated group-containing polyimide resin of the present invention was obtained by subjecting the polyimide resin to a reaction with Karenz^{™}MOI similarly as in Example 1. In this reaction solution, 25% by weight of the unsaturated group-containing polyimide resin of the present invention was contained.
Absorption maximum of the unsaturated group-containing polyimide resin by a KBr tablet method: λmax 1750 cm⁻¹.

### Example 5

Into a three-necked flask equipped with a dry nitrogen gas introducing tube, a condenser, a thermometer and a stirrer, 576 g of NMP, 25.2 g (0.2 mol) of DAHP and 30.4 g (0.2 mol) of 3,5-diaminobenzoic acid were charged, nitrogen gas was flown, and the solution was heated up to 70°C under fierce stirring. Then, 88.3 g (0.3 mol) of BPDA was added thereto, and subjected to a reaction at 70°C for 1 hour, at 90°C for 1 hour and at 100°C for 12 hours to obtain the polyamide acid varnish with a solid content of 20% by weight. This varnish had a viscosity at 25°C of 149 mPa·s.

Using the reaction solution containing the resultant polyamide acid, a reaction solution containing the polyimide resin was obtained by carrying out polyimidization similarly as in Example 1. This reaction solution had a viscosity at 25°C of 140 mPa·s. In addition, progress of nearly 100% polyimidization was confirmed similarly as in Example 1. Absorption maximum by a KBr tablet method: λmax 1751 cm⁻¹

Using the reaction solution containing the resultant polyimide acid, a reaction solution containing the unsaturated group-containing polyimide resin of the present invention was obtained by subjecting the polyimide resin to a reaction with Karenz^{™}MOI similarly as in Example 1. In this reaction solution, 18% by weight of the unsaturated group-containing polyimide resin of the present invention was contained.
Absorption maximum of the unsaturated group-containing polyimide resin by a KBr tablet method: λmax 1753 cm⁻¹.

### Example 6

Into a three-necked flask equipped with a dry nitrogen gas introducing tube, a condenser, a thermometer and a stirrer, 484 g of NMP, 25.2 g (0.2 mol) of DAHP and 30.4 g (0.2 mol) of diaminobenzoic acid were charged, nitrogen gas was flown, and the solution was heated up to 70°C under fierce stirring. Then, 65.4 g (0.3 mol) of PMDA was added thereto, and subjected to a reaction at 70°C for 1 hour, and at 100°C for 10 hours to obtain the polyamide acid varnish with a solid content of 20% by weight. This varnish had a viscosity at 25°C of 130 mPa·s. Absorption maximum by a KBr tablet method: λmax 1700 cm⁻¹

Using the reaction solution containing the resultant polyamide acid, a reaction solution containing the polyimide resin was obtained by carrying out polyimidization similarly as in Example 1. This reaction solution had a viscosity at 25°C of 140 mPa·s. In addition, progress of nearly 100% polyimidization was confirmed similarly as in Example 1. Absorption maximum by a KBr tablet method: λmax 1753 cm⁻¹

Using the reaction solution containing the resultant polyimide acid, a reaction solution containing the unsaturated group-containing polyimide resin of the present invention was obtained by subjecting the polyimide resin to a reaction with Karenz^{™} MOI similarly as in Example 1. In this reaction solution, 24% by weight of the unsaturated group-containing polyimide resin of the present invention was contained.
Absorption maximum of the unsaturated group-containing polyimide resin by a KBr tablet method: λmax 1754 cm⁻¹.

### Examples 7 to 12

By mixing each of the unsaturated group-containing polyimide resin solutions (referred to simply as the polyimide resin solution in the Table) of the present invention obtained in Examples 1 to 6, a cross-linking agent and a photo-polymerization initiator, in weight ratio shown in Table 1, each of photosensitive resin compositions of the present invention was obtained.

### (Table 1)

**Table 1 Preparation of a photosensitive resin composition (unit: g)**

| Example | A | B | initiator 1 | initiator 2 |
|---|---|---|---|---|
| 7 | 28 | 0.4 | 0.22 | 0.022 |
| 8 | 28 | 0.4 | 0.22 | 0.022 |
| 9 | 28 | 0.4 | 0.22 | 0.022 |
| 10 | 28 | 0.4 | 0.22 | 0.022 |
| 11 | 28 | 0.4 | 0.22 | 0.022 |
| 12 | 28 | 0.4 | 0.22 | 0.022 |

| | | | | |
|---|---|---|---|---|
| A: polyimide resin solution, B: cross-linking agent | | | | |

(Note) The unsaturated group-containing polyimide resin solution; each of the solution contains a resin content of about 25% by weight. Cross-linking agent; dipentaerythritol hexaacrylate (produced by NIPPON KAYAKU KABUSHIKI KAISHA) Initiator 1(a photo-polymerization initiator); Irg907 (2-methyl-1-[4-(methylthio)phenyl]-2-morpholino-propane-1-one produced by Ciba Speciality Chemical Inc.) Initiator 2: DETX-S (2,4-diethylthioxanthone), produced by NIPPON KAYAKU KABUSHIKI KAISHA)

### Examples 13 to 18

Each of the photosensitive resin compositions obtained in Examples 7 to 12 was coated onto a copper printed circuit board to be a thickness of 5 to 10 µm, by using a spin coater, and the coated film was dried in a hot air drier at 80°C for 10 minutes. Then, a mask film drawn with a pattern was adhered and irradiated by ultraviolet rays using an ultraviolet ray irradiation apparatus (500 W, multi-light, produced by USHIO Inc.). Further, by dipping in an aqueous solution of 3% by weight of sodium hydroxide as a development solution at 25°C for 1 minute, development was executed; followed by washing with water and drying in a hot air drier at 80°C for 10 minutes to obtain a cured product of the present invention. Each of the resultant cured film was subjected to a test of photosensitivity and solvent resistance. The results are shown in Table 2.

**(Table 2) Table 2 Test examples of photosensitive resin compositions**

| Example | A | B | C |
|---|---|---|---|
| Example 13 | Example 7 | O | O |
| Example 14 | Example 8 | O | O |
| Example 15 | Example 9 | O | O |
| Example 16 | Example 10 | O | O |
| Example 17 | Example 11 | O | O |
| Example 18 | Example 12 | O | O |

| | | | |
|---|---|---|---|
| (Note) A: photosensitive resin composition used, B: photosensitivity, C: solvent resistance | | | |

(Note)
Photosensitivity;
o ---shows that curing was attained under condition of an irradiation amount of equal to or lower than 2000 mJ/cm².
Solvent resistance;
o ---shows no abnormal appearance observed after dipping in isopropyl alcohol at room temperature for 30 minutes.

The photosensitive resin composition of the present invention has good development characteristic. In addition, the photosensitive resin composition of the present invention, as is clear from the results in Table 2, proved to have good performance in photosensitivity and solvent resistance.

### Test Example

### Test on flexibility

Each of photosensitive resins obtained in the above Examples 7 to 12 was coated onto a polyimide film by using a bar coater, to be a thickness of 5 µm after drying. The coated film was bent in 180° to observe change in appearance of the coated film. The following criteria was used in the evaluation:
o --- no crack observed at a coated surface
x --- crack observed at a coated surface

**Result:**

| | Flexibility |
|---|---|
| Example 13 | o |
| Example 14 | o |
| Example 15 | o |
| Example 16 | o |
| Example 17 | o |

### Industrial Applicability

The unsaturated group-containing polyimide resin of the present invention can be utilized as the photosensitive resin composition together with a cross-linking agent and a photo-polymerization initiator; the photosensitive resin composition is one having both excellent development characteristic and photosensitivity, and is capable of forming a polyimide cured product, in particular, a cured film, without requiring a heat treatment step; and the resultant cured film has flexibility and is also excellent in solvent resistance, therefore is extremely useful in applications as a solder mask of a printed wiring board or the like, and others.

## Claims

1. An unsaturated group-containing polyimide resin obtained by subjecting a polyimide resin, which is obtained by polyimidization of a polyamide acid obtained by a reaction of a diamine component (A) represented by the following formula (1): 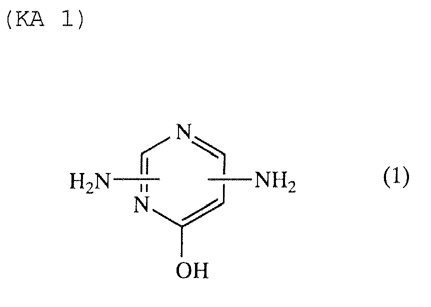 and an aromatic tetrabasic acid dianhydride (C), to a reaction with an unsaturated group-containing compound.

2. An unsaturated group-containing polyimide resin obtained by subjecting a polyimide resin, which is obtained by polyimidization of a polyamide acid obtained by a reaction of the diamine component (A) represented by the formula (1) according to claim 1, a diamine component (B) other than said diamine component (A), and an aromatic tetrabasic acid dianhydride (C), to a reaction with an unsaturated group-containing compound.

3. The unsaturated group-containing polyimide resin according to claim 1 or claim 2, wherein the aromatic tetrabasic acid dianhydride (C) is a compound represented by the following formula (2): 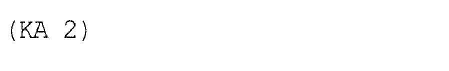 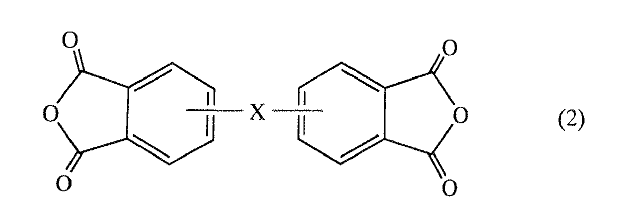 wherein X represents a direct bond, -O-, -CO- or SO₂- in the formula (2),
or a compound represented by the following formula (3):

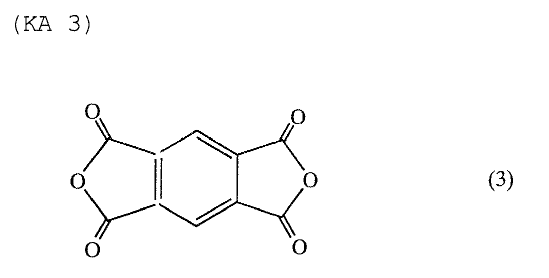

4. The unsaturated group-containing polyimide resin according to claim 2 or claim 3, wherein the diamine component (B) is at least one or more aromatic diamines selected from 4,4'-diaminodiphenyl ether, 3,4'-diaminodiphenyl ether, 1,3-bis(3-aminophenoxy)benzene, and 3,5-diaminobenzoic acid.

5. The unsaturated group-containing polyimide resin according to any one of claim 1 to claim 4, wherein the unsaturated group-containing compound is one kind or 2 or more kinds selected from a group consisting of 2-methacryloyloxyethyl isocyanate, 2-acryloyloxyethyl isocyanate and maleic anhydride.

6. A photosensitive resin composition **characterized by** comprising the unsaturated group-containing polyimide resin according to any one of claim 1 to claim 5, a cross-linking agent and a photo-polymerization initiator.

7. A cured product obtainable by curing the photosensitive resin composition according to claim 6.

8. The cured product according to claim 7, which is a flexible cured film.

9. A polyimide resin solution comprising a polyimide resin, which is obtainable by polyimidization of a polyamide acid obtained by a reaction of diamino-6-hydroxypyrimidine and an aromatic tetrabasic acid dianhydride, and a solvent.

10. The polyimide resin solution according to claim 9, wherein said polyamide acid has a viscosity at 25°C of 90 to 250 mPa·s, in the polyamide acid varnish with a solid content of 20%.
